# EUROPEAN PATENT APPLICATION

(11) **EP 4 636 425 A1**
(43) Date of publication of application: **22.10.2025**
(21) Application number: 23903389.7
(22) Date of filing: 06.12.2023
(51) Int. Cl.: G01R 31/58, G01R 31/52

(54) **VEHICLE TEST SYSTEM, VEHICLE TEST SYSTEM CABLE, AND VEHICLE TEST METHOD**

(30) Priority: 14.12.2022 JP 2022199236
(71) Applicant: HORIBA, Ltd., Kyoto-shi Kyoto 601-8510 (JP)
(72) Inventor: TOGAWA, Susumu, Kyoto-shi, Kyoto 601-8510 (JP)
(74) Representative: Müller Hoffmann & Partner
(86) International application number: PCT/JP2023/043705
(87) International publication number: WO 2024/128100

(57) **Abstract**

A vehicle test system 100 that tests a test object X being a vehicle or a part thereof, includes a test unit 10 that is provided on one side of an inside and an outside of the test object X, a control unit 20 that is provided on another side of the inside and the outside of the test object X, and controls the test unit 10, a cable 30 that connects the test unit 10 and the control unit 20, and includes a shielding layer 43 that blocks noise, and a leakage detection circuit 50 that is connected to the shielding layer 43.

## Description

### Technical Field

The present invention relates to a vehicle test system, a vehicle test system cable, and a vehicle test method.

### Background Art

As a conventional vehicle test system, Patent Literature 1 describes one in which an automatic driving robot is installed inside a vehicle, and a power supply that supplies electric power to the automatic driving robot is installed outside the vehicle.

The automatic driving robot and the power supply are connected by, for example, a cable passing through an open door or window. In order to safely control the automatic driving robot, for example, the cable has a shielding layer provided around a conductive wire so as to block noise.

However, in an attempt to perform a test with a door or a window of a vehicle closed, such as a test using an air conditioner, a problem arises in that the above-described cable is stuck in the door or the window, and when a sheath of the conductive wire is broken, an electric leakage occurs.

Note that such a problem is not limited to occurring in tests using the automatic driving robot, but can occur similarly in a case of a test using an in-vehicle exhaust gas tester, for example, in which a test unit is disposed on one side of an inside and an outside of a vehicle, and a control unit that controls the test unit is disposed on another side of the inside and the outside of the vehicle.

### Citation List

### Patent Literature

Patent Literature 1: JP 2016-18748 A

### Summary of Invention

### Technical Problem

The invention of the present application has been made to solve the above-described problem, and therefore, an object of the present invention is to achieve, in a configuration in which units installed respectively in an inside and an outside of a vehicle are connected by a cable, detection of an electric leakage occurring in the cable.

### Solution to Problem

That is, a vehicle test system according to the present invention is a vehicle test system that tests a test object being a vehicle or a part of the vehicle. The vehicle test system includes a test unit that is provided on one side of an inside and an outside of the test object, a control unit that is provided on another side of the inside and the outside of the test object, and controls the test unit, a cable that connects the test unit and the control unit, and includes a shielding layer that blocks noise, and a leakage detection circuit that is connected to the shielding layer.

According to the vehicle test system configured as described above, since the leakage detection circuit is connected to the shielding layer of the cable, when a sheath of a conductive wire is broken and an electric leakage occurs in the shielding layer, it is possible to detect the electric leakage, and thus ensure safety of the test and the like.

The cable preferably has a flat part in which a plurality of wires are arranged in a row.

This makes it easy to pass the cable through a gap of a door or a window, which is beneficial for tests performed while the door or the window is closed.

An electric leakage to the shielding layer occurs due to contact of the conductive wire through which electricity flows and the shielding layer, and thus, to lessen risk of this electric leakage, it is preferable that the wire include a plurality of conductive wires, and the shielding layer collectively cover the plurality of conductive wires.

This configuration decreases points where the shielding layer and the conductive wires are possibly in contact, and achieves a lessened risk of an electric leakage, as compared with a configuration in which the shielding layer is provided to each conductive wire.

As an aspect of implementation in which operation and effects of the present invention are remarkably exhibited, an aspect can be cited in which the cable passes through a gap of a window or a gap of a door of the test object to connect the test unit and the control unit.

This is beneficial for tests with the door or the window of the vehicle closed, such as a test using an air conditioner.

As a specific aspect of the test unit, a test unit including an actuator for operating an air conditioner that operates an air conditioner of the test object, can be cited.

With this configuration, a test can be performed while the inside of the test object is air-conditioned.

As a specific aspect of the cable, a cable that supplies electric power from the control unit to the test unit and/or a cable that communicates a signal between the control unit and the test unit, is cited.

As a more specific aspect of implementation, an aspect can be cited in which the test unit is an automatic driving robot that operates an accelerator, a brake, a clutch, and/or a shift lever of the test object, and the vehicle test system further includes a chassis dynamometer on which the vehicle is mounted, and a control device that controls the chassis dynamometer.

Examples of the test unit include an in-vehicle exhaust gas analyzer that measures a concentration of a predetermined component contained in an exhaust gas emitted from the test object.

A vehicle test system cable according to the present invention is used in a vehicle test system that tests a test object being a vehicle or a part of the vehicle, and includes a shielding layer that connects a test unit provided on one side of an inside and an outside of the test object, and a control unit provided on another side of the inside and the outside of the test object and controlling the test unit, and that blocks noise, and a leakage detection circuit that is connected to the shielding layer.

Moreover, a vehicle test method according to the present invention is a method of testing a test object being a vehicle or a part of the vehicle, and includes connecting, by a cable, a test unit that is provided on one side of an inside and an outside of the test object, and a control unit that is provided on another side of the inside and the outside of the test object and controls the test unit, and with use of a leakage detection circuit connected to a shielding layer that blocks noise contained in the cable, detecting an electric leakage to the shielding layer.

According to the vehicle test system cable and the vehicle test method, similarly to the above-described vehicle test system, when the cable is broken and an electric leakage occurs, it is possible to detect the electric leakage.

In addition, as an aspect of implementation of a test in which the operation and effects are remarkably exhibited, a test performed in a state in which an opening-closing part that is openable and closeable in the test object is closed, can be cited.

### Advantageous Effects of Invention

According to the present invention configured as described above, in the configuration in which the units installed respectively in the inside and the outside of the vehicle are connected by the cable, detection of an electric leakage to the shielding layer provided in the cable can be detected.

### Brief Description of Drawings

FIG. 1 is a schematic diagram illustrating an overall configuration of a vehicle test system according to an embodiment of the present invention.
FIG. 2 is a schematic diagram illustrating a configuration of a test unit according to the embodiment.
FIG. 3 is a schematic diagram illustrating a configuration of a cable according to the embodiment.
FIG. 4 is a schematic diagram illustrating a configuration of the cable according to the embodiment.
FIG. 5 is a schematic diagram illustrating an internal configuration of a wire according to the embodiment.
FIG. 6 is a flowchart illustrating a vehicle test method according to the embodiment.
FIG. 7 is a schematic diagram illustrating an overall configuration of a vehicle test system according to another embodiment.
FIG. 8 is a plan view schematically illustrating a configuration of a flat part of a cable according to another embodiment.
FIG. 9 is a cross-sectional view schematically illustrating a configuration of the cable according to the other embodiment.
FIG. 10 is a schematic diagram illustrating an overall configuration of a vehicle test system according to still another embodiment.

### Description of Embodiments

Hereinafter, an embodiment of a vehicle test system according to the present invention will be described with reference to the drawings.

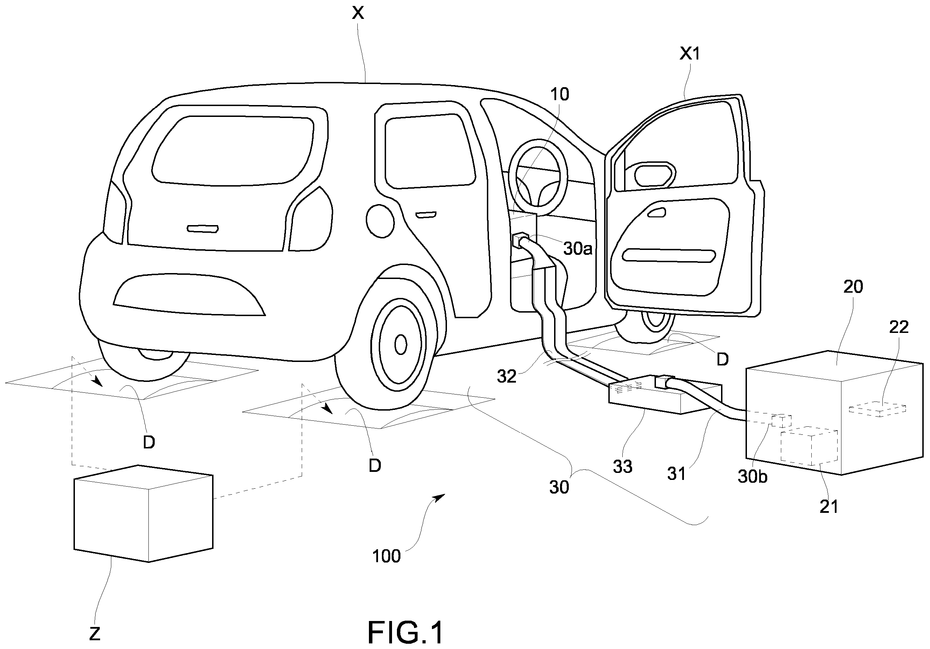

FIG. 1 illustrates a vehicle test system 100 of the present embodiment that tests a test object X that is a vehicle or a part thereof. Specifically, the vehicle test system 100 includes a test unit 10 that is used for a test, a control unit 20 that controls the test unit 10, and a cable 30 that connects the test unit 10 and the control unit 20.

A completed vehicle (hereunder, also referred to as a vehicle X) will be described as the test object X below; however, the test object, which may be a part of the vehicle X, may be, for example, a drive engine or a motor constituting the vehicle X.

As illustrated in FIG. 1, the vehicle test system 100 of the present embodiment further includes a chassis dynamometer D on which the vehicle is mounted, and a control device Z that controls the chassis dynamometer D. However, the vehicle test system 100 may include a powertrain dynamometer connected to a drive system, which is a part of the vehicle X. The control device Z may also control an operation of the test unit 10 to be described below.

The test unit 10 is provided on one side of an inside and an outside of the vehicle X and is operated by electric power supplied from the outside.

As illustrated in FIG. 1, the test unit 10 of the present embodiment is provided inside the vehicle X, is supplied with electric power from the control unit 20 to be described later, and operates based on a control signal from the control unit 20.

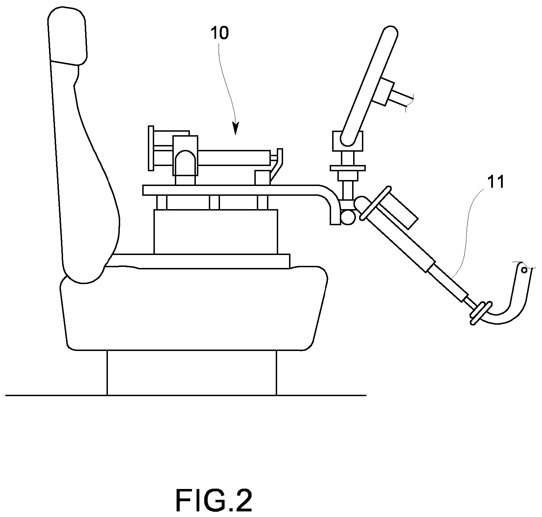

More specifically, as illustrated in FIG. 2, the test unit 10 is an automatic driving robot that operates at least one or all of an accelerator, a brake, a clutch, a shift lever, a starter switch, and the like of the vehicle X. The test unit 10 receives a control signal indicating various operation information such as an operation amount of an accelerator pedal, a depressing force of a brake pedal, operation information of a clutch, operation information of a shift lever, and/or an amount of steering operation, so that one or a plurality of actuators 11 operate.

In the present embodiment, the above-described test unit 10 or another test unit different from the test unit 10 includes an actuator for operating an air conditioner (not illustrated) that operates an air conditioner of the vehicle X.

This actuator for operating the air conditioner receives a control signal from the control unit 20 to be described below, and switches on and off of the air conditioner included in the test object X. However, the vehicle test system 100 does not necessarily have to include the actuator for operating the air conditioner, and inclusion and elimination of the actuator may be appropriately selected.

As illustrated in FIG. 1, the control unit 20 is provided on another side of the inside and the outside of the vehicle X, in other words, a side of the inside or the outside of the vehicle X where the test unit 10 is not provided. The control unit 20 is disposed inside or outside the vehicle X separately from the test unit 10.

The control unit 20 supplies electric power to the test unit 10, and drives at least a part of the test unit 10 by the electric power.

As illustrated in FIG. 1, the control unit 20 of the present embodiment includes a power supply 21 that supplies electric power to the test unit 10, and a computer that is a main body 22 of a control part. The computer outputs to the test unit 10, for example, a control signal corresponding to a test condition input beforehand.

As illustrated in FIG. 1, the cable 30 electrically connects the test unit 10 and the control unit 20 by connecting one end 30a to the test unit 10 and connecting an other end 30b to the control unit 20.

The cable 30 is used for a test in a state in which the inside of the vehicle X is closed, such as a test performed while the inside of the vehicle X is air-conditioned with an air conditioner. The cable 30 is provided between the inside and the outside of the vehicle X while passing through a gap of an opening-closing part X1 that is openable and closeable, such as a door, a window, and/or a trunk of the vehicle X.

The "state in which the inside of the vehicle X is closed" as used herein is an aspect including not only a state in which the opening-closing part X1, such as a door, a window, and/or a trunk, is completely closed, but also a state made by slightly opening the opening-closing part X1 to make a gap, passing the cable 30 through part of the gap, and sealing the remaining part of the gap with a sealing material, such as a sealing tape.

That is, the cable 30 passes through the gap in a state in which the inside of the vehicle X is closed.

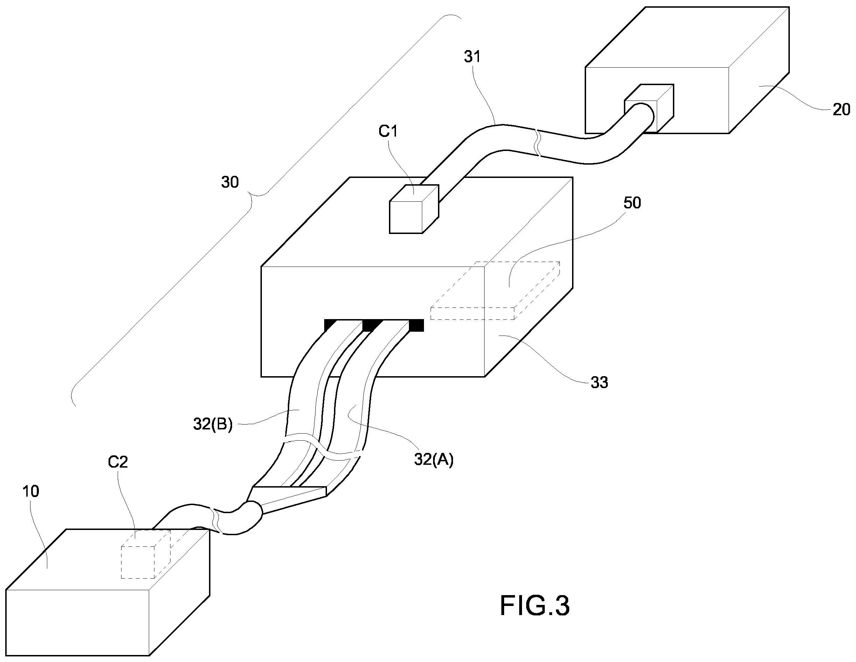

As illustrated in FIG. 3, the cable 30 of the present embodiment includes a round part 31 provided on the control unit 20 side, a flat part 32 provided on the test unit 10 side, and a cable conversion part 33 interposed between the round part and the flat part.

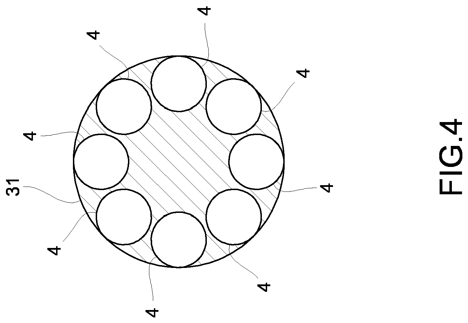

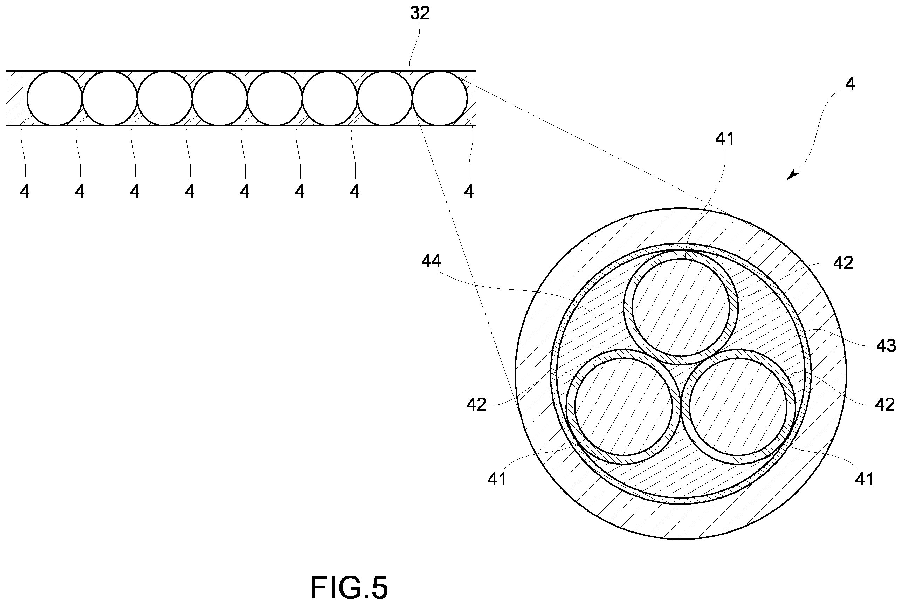

To be more specific, the round part 31 is formed by bundling a plurality of wires 4 such that the round part 31 has a circular cross section as illustrated in FIG. 4, while as illustrated in FIG. 5, the flat part 32 is formed by arranging the plurality of wires 4 constituting the round part 31 in a row.

The round part 31 and the flat part 32 are connected via the cable conversion part 33 disposed outside the vehicle X, as illustrated in FIG. 1. That is, in the present embodiment, as illustrated in FIG. 1, the control unit 20, the round part 31, the cable conversion part 33, the flat part 32, and the test unit 10 are arranged in this order from the outside to the inside of the vehicle X. The flat part 32 is passed through the gap of the opening-closing part X1 to be sealed.

As illustrated in FIG. 3, one end of the round part 31 is connected to the control unit 20, and an other end thereof is connected to the cable conversion part 33 via a first connector C1.

On the other hand, as illustrated in FIG. 3, one end of the flat part 32 is connected to the cable conversion part 33 and another end thereof is connected to the test unit 10 via a second connector C2. In this embodiment, the other end of the flat part 32 is formed by bundling the plurality of wires 4 in a circular shape. This means that the first connector C1 and the second connector C2 have a common configuration (that is, the connectors are the same). However, the first connector C1 and the second connector C2 may have different configurations.

As illustrated in FIG. 3, the flat part 32 is provided with a power supply flat section 32(A) that supplies electric power from the control unit 20 to the test unit 10, and a control flat section 32(B) that communicates a signal between the control unit 20 and the test unit 10.

Specifically, the power supply flat section 32(A) is composed of a plurality of the wires 4 for supplying electric power from the control unit 20 to the test unit 10, and the control flat section 32(B) is composed of a plurality of the wires 4 for communicating a signal between the control unit 20 and the test unit 10.

That is, in this embodiment, one round part 31 is converted into two flat parts 32 via the cable conversion part 33.

To describe the flat part 32 more specifically, as illustrated in FIG. 5, the flat part 32 has a flat shape in which the plurality of wires 4 are arranged in a row, and has a thickness sufficiently smaller than a width.

For example, the flat part 32 has a thickness of 1/10 or less of the width, and in this case, of 1/20 or less. The thickness is, for example, about 3 mm or more to about 10 mm or less.

The plurality of wires 4 serve to supply electric power to a motor included in the test unit 10, for example, and more specifically, as illustrated in FIG. 5, each include a plurality of conductive wires 41 through which a current flows, insulating layers 42 that cover the conductive wires 41, and a shielding layer 43 that surrounds the insulating layers 42. Note here that a flexible material 44, such as cotton string, is interposed between the insulating layers 42 and the shielding layer 43 such that the wire 4 has flexibility.

The plurality of conductive wires 41 are arranged in a bundle while centered on the wire 4, and in the present embodiment, carry a three-phase alternating current corresponding to a U phase, a V phase, and a W phase. The conductive wires 41 may, however, carry a single-phase alternating current.

The insulating layer 42 covers the entire conductive wire 41 to insulate the conductive wire 41 from surroundings, and is made of, for example, resin. The insulating layer 42 is provided correspondingly to each of the plurality of conductive wires 41, in other words, the plurality of conductive wires 41 are covered with respective different insulating layers 42.

The shielding layer 43 blocks noise produced by the current flowing through the conductive wires 41, and also obviates the noise from leaking to an outside of the cable 30. Note that a shielding layer 43 provided in the control flat section 32(B) obviates noise from flowing into the cable 30 from the outside. These shielding layers 43 are made of, for example, copper having conductivity, and each cover a plurality of the conductive wires 41 collectively.

In this configuration, however, when the insulating layer 42 covering the conductive wire 41 is broken and the conductive wire 41 and the shielding layer 43 come into contact, an electric leakage occurs from the conductive wire 41 to the shielding layer 43.

To avoid this situation, the cable 30 of the present embodiment includes a leakage detection circuit 50 connected to the shielding layer 43, as illustrated in FIG. 3.

The leakage detection circuit 50 is electrically connected to the shielding layer 43 and detects a current flowing through the shielding layer 43. The leakage detection circuit 50 may have, as an example of a specific configuration, a detection circuit that detects a current using a resistance element, a comparator that compares a detected current with a predetermined threshold value, and a detection holding circuit, such as a latch circuit, that holds information indicating that an electrical leakage is detected by the comparator. However, the specific configuration of the leakage detection circuit 50 is not limited thereto, and the configuration may be appropriately changed.

The leakage detection circuit 50 is configured to detect a current flowing through the shielding layer 43, and in this embodiment, is accommodated in a casing constituting the above-described cable conversion part 33. However, an arrangement of the leakage detection circuit 50 may be appropriately changed.

In the present embodiment, the cable 30 is composed of the plurality of wires 4, and the plurality of wires 4 are provided with the shielding layers 43; however, the plurality of wires 4 may be provided with respective shielding layers 43. In this case, the leakage detection circuit 50 is configured to be connected to the shielding layer 43 of each of the plurality of wires 4, and detect an electric leakage in each of the shielding layers 43.

That is, the leakage detection circuit 50 of the present embodiment is connected to the wires 4 for supplying electric power from the control unit 20 to the test unit 10 and the wires 4 for communicating a signal between the control unit 20 and the test unit 10, and detects an electric leakage in the shielding layers 43 provided in these wires 4.

The leakage detection circuit 50 may, however, be connected only to the wires 4 for supplying electric power from the control unit 20 to the test unit 10 and detect an electric leakage in the shielding layers 43 provided in these wires 4.

Alternatively, the leakage detection circuit 50 may be connected only to the wires 4 for communicating a signal between the control unit 20 and the test unit 10 and detect an electric leakage in the shielding layers 43 provided in these wires 4.

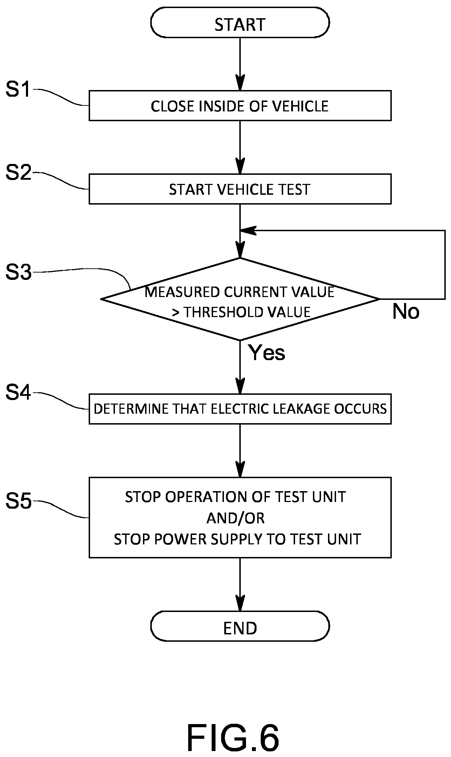

Hereinafter, as an example of a vehicle test using the present invention, a method of a vehicle test in a state in which an air conditioner of a vehicle is in operation will be described with reference to a flowchart of FIG. 6.

First, a performance test of the vehicle X is started, then the inside of the vehicle X is closed (S1). In this embodiment, the actuator for operating the air conditioner receives a control signal from the control unit 20 and turns on the air conditioner. At this time, the flat part 32 of the cable 30 passes through the opening-closing part X1, and the opening-closing part X1 is closed. Incidentally, the air conditioner may be manually operated by an operator.

Next, the test unit 10 operates the accelerator, the brake, the clutch, and/or the shift lever of the vehicle X to drive the vehicle X on the chassis dynamometer D, and the vehicle test is started (S2).

Then, the leakage detection circuit 50 measures a current flowing through the shielding layer 43 and compares a measured current value with a predetermined threshold value (S3).

In S3, when the measured current value exceeds the threshold value, the leakage detection circuit 50 determines that an electric leakage occurs in the shielding layer 43, and outputs a leakage detection signal indicating that effect (S4).

The leakage detection signal is output to the control unit 20, for example. The control unit 20, when acquiring the leakage detection signal, stops the operation of the test unit 10 and/or stops the power supply to the test unit 10, for example (S5).

On the other hand, when the measured current value does not exceed the threshold value in S3, the leakage detection circuit 50 repeats the comparison in S3 until the vehicle test is finished.

According to the vehicle test system 100 configured as described above, since the leakage detection circuit 50 is connected to the shielding layer 43 of the cable 30, when the insulating layer 42 covering the conductive wire 41 is broken to cause an electric leakage in the shielding layer 43, it is possible to detect the electric leakage and thus ensure safety of the test and the like.

Moreover, since the cable 30 has the flat part 32 in which the plurality of wires 4 are arranged in a row, the cable can be easily passed through the gap of the door or the window. This is beneficial for tests performed while the door or the window is closed.

Furthermore, since a plurality of the conductive wires 41 are collectively covered with the shielding layer 43, as compared with a configuration in which one shielding layer 43 is provided to one conductive wire 41, points where the shielding layer 43 and the conductive wires 41 are possibly in contact decrease, risks of an electric leakage can be lessened, and in addition, a thickness of each wire 4 can be reduced, and the cable can be easily passed through the gap of the window or the door.

Note that the present invention is not limited to the above embodiment.

In the above embodiment, for example, the test unit 10 has been described by taking the automatic driving robot as an example. However, the test unit may be of various types as long as it is used to test the performance of the test object X, such as an in-vehicle exhaust gas analyzer.

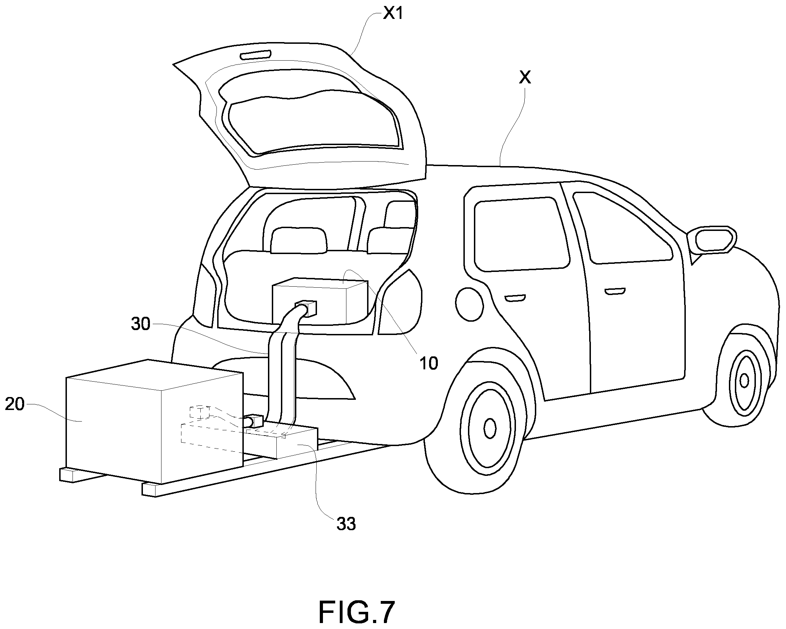

In the above embodiment, the test unit 10 is disposed inside the vehicle X, and the control unit 20 is disposed outside the vehicle X. However, as illustrated in FIG. 7, a reversed arrangement may be made, in which, for example, a test unit 10, such as an in-vehicle exhaust gas analyzer, may be disposed on a mounting member attached to the outside of a vehicle (test object) X, and a control unit 20 that controls the test unit 10 may be disposed inside the vehicle X. The in-vehicle exhaust gas analyzer measures a concentration of a predetermined component contained in the exhaust gas of the vehicle X while being mounted on the vehicle X being traveling. Examples of the predetermined component include CO, CO₂, NOx, THC, NH₃, particle matter (PM), and/or particle number (PN).

Further, the cable conversion part 33 is disposed outside the vehicle X in the embodiment described earlier, but may be disposed inside the vehicle X. That is, the test unit 10, a round part 31, a cable conversion part 33, a flat part 32, and the control unit 20 may be arranged in this order from the inside to the outside of the vehicle X. With such an arrangement as well, the flat part 32 can pass through an opening-closing part X1.

Moreover, a cable 30 does not necessarily have to include the round part 31, and may be entirely composed of the flat part 32. In this case, the cable conversion part 33 can be omitted, and the leakage detection circuit 50 may be provided in the test unit 10 or the control unit 20, for example.

Furthermore, the cable 30 does not necessarily have to include the flat part 32, and may be entirely composed of the round part 31.

In the cable 30 of the embodiment described earlier, the power supply flat section 32(A) and the control flat section 32(B) are separate; however, the power supply flat section 32(A) and the control flat section 32(B) may be integrally provided. The cable 30 in this case can be made by converting the round part 31 into a single flat part 32.

However, from the viewpoint of curbing influence of noise produced in the power supply flat section 32(A) on the control flat section 32(B), it is preferable that the power supply flat section 32(A) and the control flat section 32(B) be separate as in the embodiment described earlier.

The cable 30 may be composed of a single conductive wire 41. Alternatively, the cable 30 may be composed of the plurality of conductive wires 41 covered with respective different shielding layers 43.

The cable 30 in the embodiment described earlier supplies electric power to the test unit 10 and exchanges control signals between the test unit 10 and the control unit 20; however, the cable 30 may be used only for the power supply or only for the exchange of control signals.

The leakage detection circuit 50 may be configured to notify that an electric leakage has been detected to the shielding layer 43 when it happens.

The flat part 32 of the cable 30 is fixed by fusing, or other means, the plurality of wires 4, but in this flat part 32, there is a risk of the fused area peeling off with use to cause the plurality of wires 4 to come apart. In this case, the plurality of wires 4, after coming apart, overlap each other to cause difficulty in closing the window or the door in some cases. If the window or the door is forcibly closed in this state, a risk of disconnection or a short circuit arises, resulting in an electric leakage.

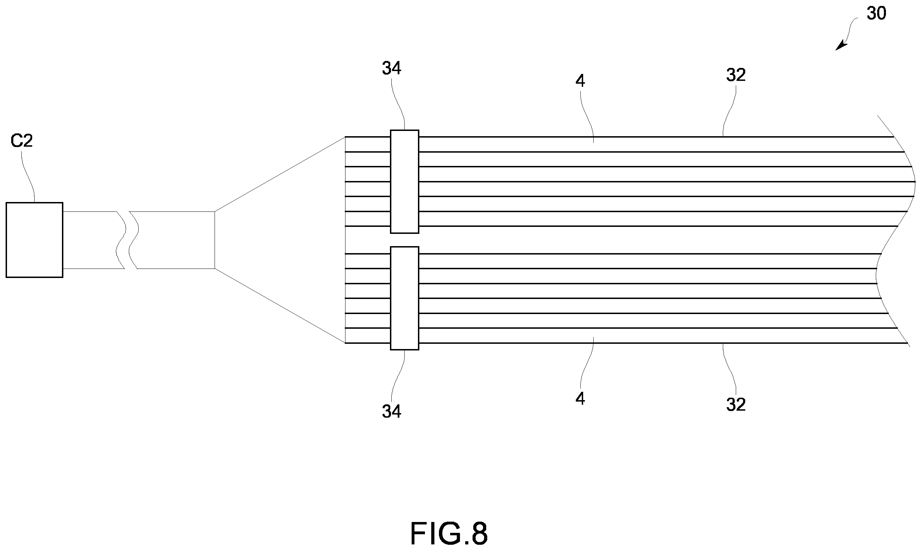

To avoid this risk, as illustrated in FIG. 8, a cable 30 of another embodiment may include a band member 34 that binds a plurality of wires 4 constituting a flat part 32 and fused to each other such that the wires 4 do not come apart with use. The band member 34 of the present embodiment is formed of a heat shrinkable tube that shrinks by heating. The band member 34 is preferably attached to an end of the flat part 32 where a fused area easily peels off (starts to tear easily), and more preferably, attached to an end closer to a second connector C2. This makes it possible to avoid peeling of the fused area with the use of the flat part 32.

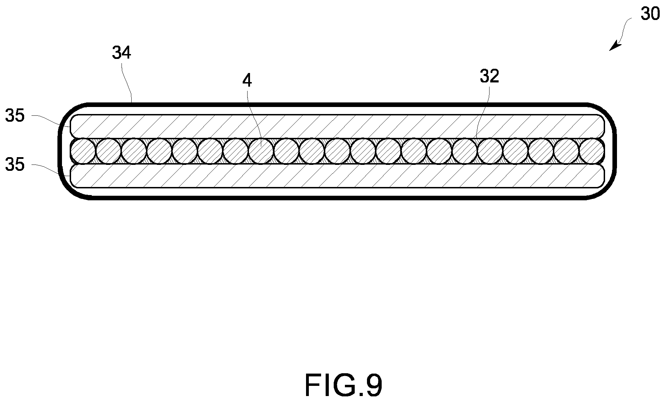

The band member 34 is, when attached, preferably attached to the flat part 32 via a reinforcing member 35 having higher rigidity than that of the flat part 32. This reinforcing member 35 serves to avoid curling up of the flat part 32 when the band member 34 is attached, and is made of resin, such as Bakelite (phenol resin) and polyurethane foam, or metal, for example. As illustrated in FIG. 9, the reinforcing member 35 has a cross section having a shape extending to cover each of an upper side and a lower side of the flat part 32. The reinforcing member 35 may be provided only on one side of the upper side and the lower side of the flat part 32, or may be provided on both sides. A surface shape of the reinforcing member 35 may be formed to substantially conform to a surface shape (specifically, a surface shape formed by bundling the plurality of wires 4) of the flat part 32 in contact with the reinforcing member 35.

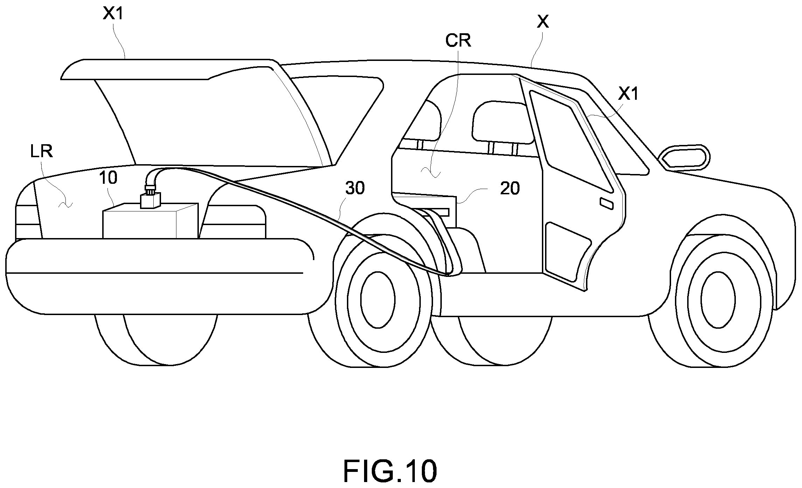

As illustrated in FIG. 10, a vehicle test system 100 of still another embodiment may also be used to test a vehicle (test object) X of a type of which a luggage space is independent of a vehicle cabin (for example, a type inaccessible to a luggage space from a vehicle cabin, such as a sedan). In this case, as illustrated in FIG. 10, a test unit 10 may be mounted on a luggage space LR of the vehicle X, a control unit 20 may be mounted on a vehicle cabin CR (rear seat, for example) of the vehicle X, and a cable 30 may be disposed to pass through gaps of two opening-closing parts X1 (i.e., a luggage space door and a vehicle cabin door). That is, in this case, the vehicle cabin CR of the test object X corresponds to the "inside of the test object" in the present invention, and the luggage space LR inaccessible from the vehicle cabin CR corresponds to the "outside of the test object" in the present invention.

The present invention is not limited to the embodiments described above, and it goes without saying that various modifications can be made without departing from the gist of the present invention.

### Industrial Applicability

According to the vehicle test system of the present invention, in the configuration in which the units installed respectively in the inside and the outside of the vehicle are connected by the cable, detection of an electric leakage occurring in the cable can be detected. Reference Signs List

- 100: vehicle test system
- X: test object
- X1: opening-closing part
- 10: test unit
- 11: actuator
- 20: control unit
- 21: power supply
- 22: computer
- 30: cable
- 30a: one end
- 30b: other end
- 31: round part
- 32: flat part
- 33: cable conversion part
- C1: first connector
- C2: second connector
- 4: wire
- 41: conductive wire
- 42: insulating layer
- 43: shielding layer
- 44: flexible material
- 50: leakage detection circuit

## Claims

1. A vehicle test system that tests a test object being a vehicle or a part of the vehicle, comprising:
a test unit that is provided on one side of an inside and an outside of the test object;
a control unit that is provided on another side of the inside and the outside of the test object, and controls the test unit;
a cable that connects the test unit and the control unit, and includes a shielding layer that blocks noise; and
a leakage detection circuit that is connected to the shielding layer.

2. The vehicle test system according to claim 1, wherein the cable includes a flat part in which a plurality of wires are arranged in a row.

3. The vehicle test system according to claim 2, wherein the wire includes a plurality of conductive wires, and the shielding layer covers the plurality of conductive wires collectively.

4. The vehicle test system according to any one of claims 1 to 3, wherein the cable passes through a gap of a window or a gap of a door of the test object to connect the test unit and the control unit.

5. The vehicle test system according to any one of claims 1 to 4, wherein the test unit includes an actuator for operating an air conditioner that operates an air conditioner of the test object.

6. The vehicle test system according to any one of claims 1 to 5, wherein the cable supplies electric power from the control unit to the test unit.

7. The vehicle test system according to any one of claims 1 to 6, wherein the cable communicates a signal between the control unit and the test unit.

8. The vehicle test system according to any one of claims 1 to 7, wherein the test unit is an automatic driving robot that operates an accelerator, a brake, a clutch, and/or a shift lever of the test object; and
the vehicle test system further comprises:
a chassis dynamometer on which the vehicle is mounted; and
a control device that controls the chassis dynamometer.

9. The vehicle test system according to any one of claims 1 to 7, wherein the test unit is an in-vehicle exhaust gas analyzer that measures a concentration of a predetermined component contained in an exhaust gas emitted from the test object.

10. A vehicle test system cable used in a vehicle test system that tests a test object being a vehicle or a part of the vehicle, the vehicle test system cable comprising:
a shielding layer that connects a test unit provided on one side of an inside and an outside of the test object, and a control unit provided on another side of the inside and the outside of the test object and controlling the test unit, and that blocks noise; and
a leakage detection circuit that is connected to the shielding layer.

11. A vehicle test method of testing a test object being a vehicle or a part of the vehicle, comprising:
connecting, by a cable, a test unit that is provided on one side of an inside and an outside of the test object, and a control unit that is provided on another side of the inside and the outside of the test object and controls the test unit; and
with use of a leakage detection circuit connected to a shielding layer that blocks noise contained in the cable, detecting an electric leakage to the shielding layer.

12. The vehicle test method according to claim 11, wherein a test is performed in a state in which an opening-closing part that is openable and closeable in the test object is closed.
